# EUROPEAN PATENT APPLICATION

(11) **EP 4 727 283 A1**
(43) Date of publication of application: **15.04.2026**
(21) Application number: 25208508.9
(22) Date of filing: 14.10.2025
(51) Int. Cl.: H10D 1/68, H10P 52/40, H10B 41/30, H10P 95/00

(54) **SEMICONDUCTOR DEVICE AND METHOD OF FABRICATING THE SAME**

(30) Priority: 14.10.2024 CN 202411434662
(71) Applicant: GigaDevice Semiconductor (Shanghai) Inc., Shanghai 201210 (CN); GigaDevice Semiconductor Inc., Haidian, Beijing (CN)
(72) Inventor: LI, Xiaokang, Shanghai, 201210 (CN); XU, Yisheng, Shanghai, 201210 (CN); FENG, Jun, Shanghai, 201210 (CN); QIAN, Meng, Shanghai, 201210 (CN)
(74) Representative: dompatent

(57) **Abstract**

The present invention provides a semiconductor device and a method of fabricating the same, which includes: providing a semiconductor substrate (100) having a first patterned region (110) and a second patterned region (120) and performing floating-gate poly-Si deposition on the semiconductor substrate thereby forming a first poly-Si layer (210), wherein the first patterned region has a higher feature density than the second patterned region; performing ion implantation on the first poly-Si layer and forming an oxide layer over a top surface of the first poly-Si layer; with the oxide layer in the second patterned region being protected, etching the oxide layer in the first patterned region; performing a CMP process on the first poly-Si layer in the first patterned region and on the oxide layer and the first poly-Si layer in the second patterned region; and forming the semiconductor device on the basis of the first poly-Si layer that has undergone the CMP process.

## Description

### TECHNICAL FIELD

The present invention relates to the field of semiconductor technology and, in particular, to a semiconductor device and a method of fabricating a semiconductor device.

### BACKGROUND

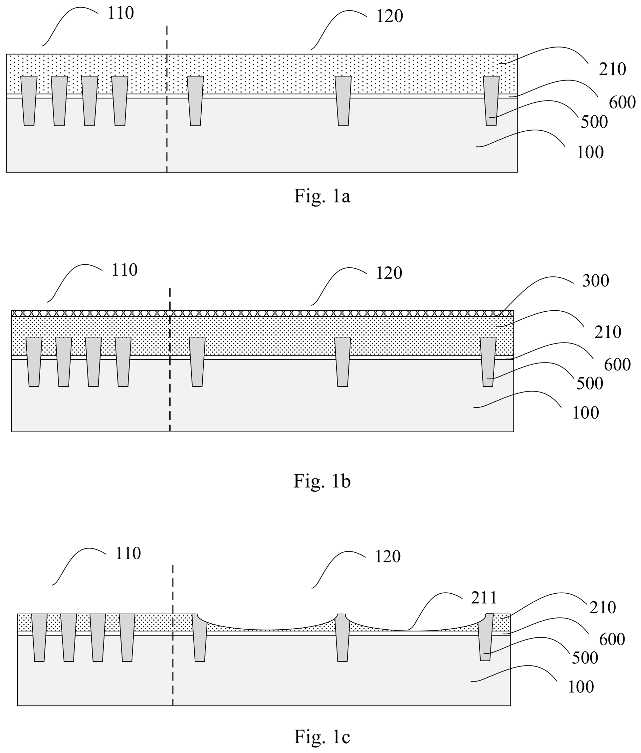

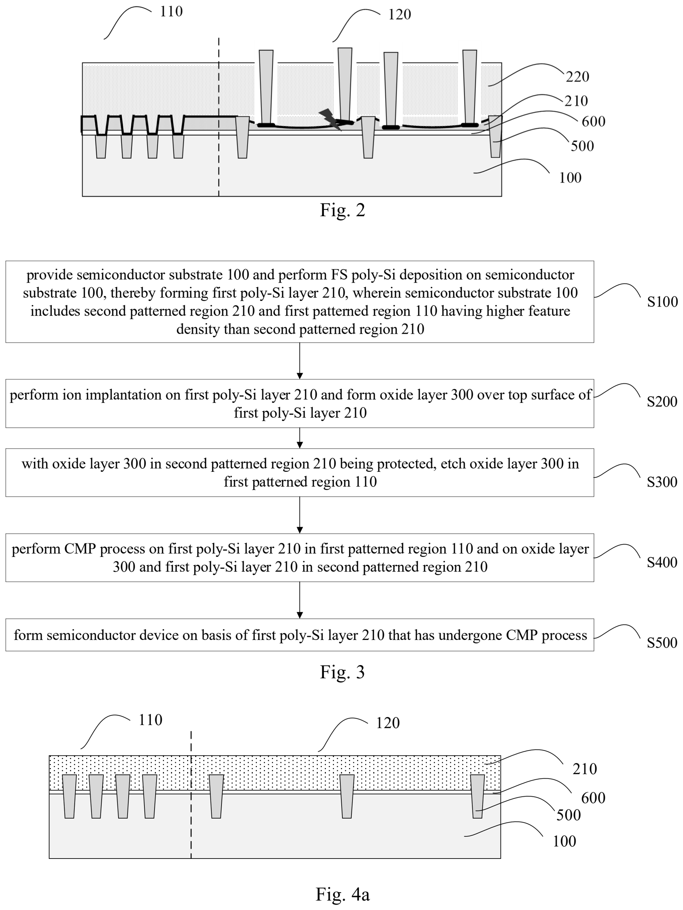

Poly-insulator-poly (PIP) capacitors are parasitic capacitors on floating-gate memory platforms. A PIP capacitor is a high-capacitance capacitor consisting of a capacitor corresponding to an inter-gate dielectric layer and a capacitor corresponding to a tunnel oxide layer, which are connected in parallel in a floating-gate memory cell. Existing PIP capacitors are parallel-plate capacitors and primarily used in charge pump boost circuits and filter circuits. Reference is made to Figs. 1a to 1c, cross-sectional views of intermediate semiconductor structures resulting from steps in a method of fabricating a semiconductor device in the related art, and to Fig. 2, a schematic diagram illustrating how dishing affects the reliability of the semiconductor device, which is, for example, a PIP capacitor. As shown in the schematic cross-sectional view of Fig. 1a, the fabrication of the parallel-plate capacitor includes forming, in a first patterned region 110 and a second patterned region 120, multiple isolation structures 500, an insulating layer 600 and a first polycrystalline silicon (poly-Si) layer 210 stacked on the insulating layer 600. As shown in the schematic cross-sectional view of Fig. 1b, the fabrication also includes forming an ultrathin oxide layer 300 on the first poly-Si layer 210. As shown in the schematic cross-sectional view of Fig. 1c, the fabrication also includes performing a chemical mechanical polishing (CMP) process on the oxide layer 300 and the first poly-Si layer 210. However, as shown in Figs. 1c and 2, due to a significant feature density between the array region (i.e., the first patterned region 110) and the PIP capacitor region (i.e., the second patterned region 120), significant dishing 211 may occur in the PIP capacitor region during the floating-gate (FG) CMP process, leading to an undesirably small FG thickness in the region. As shown in Fig. 2, in serious cases, the reliability of the resulting PIP capacitors may be affected (e.g., due to contact of a second poly-Si layer 220 with the first poly-Si layer 210).

It should be noted that the information disclosed in this Background section is merely intended to provide a better understanding of the general context of the present invention and should not be taken as an acknowledgement or any form of admission that the information forms part of the common general knowledge of those skilled in the art.

### SUMMARY

As noted above, conventional fabrication of a semiconductor device may involve polishing of patterned regions with different feature densities, and dishing may occur in the polished lower-density patterned region. In view of this problem, it is an object of the present invention to provide a method of fabricating a semiconductor device, which ensures that a poly-Si layer has a uniform thickness across regions with different feature densities, improving the reliability of the resulting semiconductor device. Moreover, the method entails a simple process, which is highly flexible and easy to implement.

To this end, the present invention provides a method of fabricating a semiconductor device, which includes:
providing a semiconductor substrate and performing floating-gate (FS) polycrystalline silicon (poly-Si) deposition on the semiconductor substrate, thereby forming a first poly-Si layer, wherein the semiconductor substrate includes a first patterned region and a second patterned region, the first patterned region having a higher feature density than the second patterned region;
performing ion implantation on the first poly-Si layer and forming an oxide layer over a top surface of the first poly-Si layer;
with the oxide layer in the second patterned region being protected, etching the oxide layer in the first patterned region;
performing a chemical mechanical polishing (CMP) process on the first poly-Si layer in the first patterned region and on the oxide layer and the first poly-Si layer in the second patterned region; and
forming the semiconductor device on the basis of the first poly-Si layer that has undergone the CMP process.

Optionally, the method may include forming the oxide layer over the top surface of the first poly-Si layer by thermal oxidation.

Optionally, the oxide layer may have a thickness of 20 Å to 30 Å.

Optionally, the protection of the oxide layer in the second patterned region may include stacking a protective layer on a top surface of the oxide layer in the second patterned region.

Optionally, the protective layer may include a photoresist layer.

Optionally, etching the oxide layer in the first patterned region may include removing the oxide layer from the first patterned region by wet etching.

Optionally, the oxide layer may be removed from the first patterned region by performing a wet etching process using hydrofluoric acid. Optionally, the formation of the semiconductor device on the basis of the first poly-Si layer that has undergone the CMP process may include:
forming, over the top surface of the first poly-Si layer, at least an insulating dielectric layer and a second poly-Si layer stacked thereon; and selectively etching the first poly-Si layer, the insulating dielectric layer and the second poly-Si layer, thereby forming the semiconductor device.

Optionally, poly-insulator-poly (PIP) capacitors may be formed in the second patterned region, wherein the second and first poly-Si layers provide top and bottom plates of the PIP capacitors, respectively.

Optionally, an array of memory cells may be formed in the first patterned region, wherein second and first poly-Si layers provide control gates and floating gates of the memory cells, respectively.

Optionally, the method may further include, before the FS poly-Si deposition is performed on the semiconductor substrate:
forming an insulating layer over the semiconductor substrate and a plurality of isolation structures in the semiconductor substrate on the side thereof proximal to the insulating layer so that top surfaces of the resulting isolation structures are raised over a top surface of the insulating layer,
wherein the formation of the first poly-Si layer on the semiconductor substrate by the FS poly-Si deposition includes:
   forming the first poly-Si layer on the top surface of the insulating layer by the FS poly-Si deposition so that a top surface of the first poly-Si is higher than the top surfaces of the isolation structures.

The present invention also provides a semiconductor device which including:
a semiconductor substrate including a first patterned region and a second patterned region, wherein the first patterned region has a feature density higher than a feature density of the second patterned region;
a first poly-Si layer disposed over the semiconductor substrate;
wherein the first poly-Si layer has a substantially uniform thickness in both the first patterned region and the second patterned region.

Optionally, in the semiconductor device, a top surface of the first poly-Si layer is planar and is devoid of dishing in the second patterned region.

Optionally, the semiconductor device further includes: an insulating layer disposed on the first poly-Si layer; and a second poly-Si layer disposed on the insulating dielectric layer.

Optionally, in the semiconductor device, poly-insulator-poly capacitors are formed in the second patterned region, wherein the second poly-Si layer and the first poly-Si layer provide a top plate and a bottom plate of the poly-insulator-poly capacitors, respectively.

Optionally, in the semiconductor device, the bottom plate of the poly-insulator-poly capacitors has a planar top surface.

Optionally, in the semiconductor device, an array of memory cells is formed in the first patterned region, wherein the second poly-Si layer and the first poly-Si layer provide control gates and floating gates of the memory cells, respectively.

Optionally, the semiconductor device further includes an insulating layer over the semiconductor substrate and a plurality of isolation structures in the semiconductor substrate on the side thereof proximal to the insulating layer, top surfaces of the isolation structures are raised over a top surface of the insulating layer.

Optionally, in the semiconductor device, a top surface of the first poly-Si is higher than the top surfaces of the isolation structures.

Optionally, in the semiconductor device, the isolation structures are denser in the first patterned region than in the second patterned region.

The method of the present invention has the following advantages over the prior art:
In the method, a first poly-Si layer is first formed on a semiconductor substrate by FS poly-Si deposition, laying a foundation for the formation of poly-Si electrodes (e.g., in the case of the semiconductor device including PIP capacitors), high-resistance poly-Si or the like. This is followed by ion implantation, which can modify the conductivity, magnetic permeability and other properties of the first poly-Si layer, laying a foundation for further improving the performance of the semiconductor device. Additionally, an oxide layer is formed on a top surface of the first poly-Si layer, which can not only prevent possible damage to the surface of the first poly-Si layer due to contamination and thereby provide protection to the first poly-Si layer, but can also facilitate performance of the subsequent processes. Furthermore, with the oxide layer in the second patterned region being protected, the oxide layer in the first patterned region is etched (e.g., in order to remove the oxide layer from the first patterned region, with the oxide layer in the second patterned region being retained). In this way, in the subsequent CMP on the first poly-Si layer in the first patterned region and on the oxide layer and the first poly-Si layer in the second patterned region, the property of the polishing slurry used that it can polish away the oxide layer in spite of a slow removal rate is fully utilized to enable the first poly-Si layer to eventually have a uniform thickness across the first and second patterned regions because of a higher polishing rate of the second patterned region due to the loading effect following the removal of the oxide layer, thereby improving the reliability of the resulting semiconductor device while entailing a simple process, which is highly flexible and easy to implement.

### BRIEF DESCRIPTION OF THE DRAWINGS

Figs. 1a to 1c show cross-sectional views of intermediate semiconductor structures resulting from steps in a method of fabricating a semiconductor device in the related art.
Fig. 2 schematically illustrates how dishing affects the reliability of a semiconductor device, which is, for example, a PIP capacitor.
Fig. 3 schematically illustrates an overall flowchart of a method of fabricating a semiconductor device according to an embodiment of the present invention.
Figs. 4a to 4d show cross-sectional views of intermediate semiconductor structures resulting from steps in a method of fabricating a semiconductor device according to an embodiment of the present invention.

### List of Reference Numerals

100, semiconductor substrate; 110, first patterned region; 120, second patterned region;
210, first polycrystalline silicon layer; 220 second polycrystalline silicon layer; 211, dishing; 300, oxide layer; 400 protective layer; 500 isolation structure; 600 insulating layer.

### DETAILED DESCRIPTION

Methods of fabricating a semiconductor device proposed herein will be described in greater detail below with reference to the accompanying drawings. From the following description, advantages and features of the present invention will be more apparent. Note that the figures are provided in a very simplified form not necessarily drawn to exact scale for the only purpose of helping to explain the disclosed embodiments in a more convenient and clearer way. In order that the objects, features and advantages of the present invention can be more apparent and readily understood, reference is to be made to the accompanying drawings. It would be recognized that architectural, proportional, dimensional and other details in the figures are presented only for the purpose of facilitating, in conjunction with the disclosure herein, the understanding and reading of those familiar with the art, rather than being intended to limit conditions under which the present invention can be implemented. Therefore, any and all architectural modifications, proportional variations or dimensional changes that achieve the same or similar benefits and objects as the present invention are considered to fall within the scope of the teachings herein. The specific design features of the invention as disclosed herein, including, for example, specific dimensions, orientations, locations and shapes, will be determined in part by the particular intended application and use environment. Additionally, in the embodiments described below, like reference numerals may be sometimes used to refer to the same or functionally similar elements throughout different figures, while description thereof may not be repeated. In this specification, similar reference numerals and letters refer to similar items in the figures, and thus once an item is defined in one figure, it may not be discussed for following figures. Further, if a method is described herein as comprising a series of steps, the order of these steps as presented herein is not necessarily the only order in which they can be performed, and some of the stated steps may be omitted and/or other steps not described herein may be added to the method.

It is to be noted that, as used herein, relational terms such as first and second, etc., are only used to distinguish one entity or operation from another entity or operation, and do not necessarily require or imply these entities having such an order or sequence. Moreover, the terms "comprise," "include," or any other variations thereof are intended to cover a nonexclusive inclusion within a process, method, article, or apparatus that includes a list of elements including not only those elements but also those that are not explicitly listed, or other elements that are inherent to such processes, methods, goods, or equipment. In the case of no more limitation, the element defined by the sentence "includes a ..." does not exclude the existence of another identical element in the process, the method, or the device including the element. As used herein, the singular forms "a", "an" and "the" include plural referents, and the term "or" is generally employed in the sense of "and/or", "a number of" of "at least one", and "at least two" of "two or more". Additionally, the use of the terms "first", "second" and "third" herein is intended for illustration only and is not to be construed as denoting or implying relative importance or as implicitly indicating the numerical number of the referenced items.

It is a principle object of the present invention to provide a method of fabricating a semiconductor device, which ensures that a polycrystalline silicon (poly-Si) layer has a uniform thickness across regions with different feature densities, improving the reliability of the resulting semiconductor device. Moreover, the method entails a simple process, which is highly flexible and easy to implement.

For example, reference is made to Figs. 3 and 4a to 4d. Fig. 3 schematically illustrates an overall flowchart of a method of fabricating a semiconductor device according to an embodiment of the present invention, and Figs. 4a to 4d show cross-sectional views of intermediate semiconductor structures resulting from steps in the method. As can be seen from Fig. 3, the method includes:
S100) providing a semiconductor substrate 100 and performing floating-gate (FS) polycrystalline silicon (poly-Si) deposition on the semiconductor substrate 100, thereby forming a first poly-Si layer 210, wherein the semiconductor substrate 100 includes a first patterned region 110 and a second patterned region 120, the first patterned region 110 having a higher feature density than the second patterned region 120;
S200) performing ion implantation on the first poly-Si layer 210 and forming an oxide layer 300 over a top surface of the first poly-Si layer 210;
S300) with the oxide layer 300 in the second patterned region 120 being protected, etching the oxide layer 300 in the first patterned region 110;
S400) performing a chemical mechanical polishing (CMP) process on the first poly-Si layer 210 in the first patterned region 110 and on the oxide layer 300 and the first poly-Si layer 210 in the second patterned region 120; and
S500) forming the semiconductor device on the basis of the first poly-Si layer 210 that has undergone the CMP process.

In this method, FS poly-Si deposition is first carried out on a semiconductor substrate 100 to form a first poly-Si layer 210, laying a foundation for the formation of poly-Si electrodes (e.g., in the case of the semiconductor device including poly-insulator-poly (PIP) capacitors), high-resistance poly-Si or the like. This is followed by ion implantation, which can modify the conductivity, magnetic permeability and other properties of the first poly-Si layer 210, laying a foundation for further improving the performance of the semiconductor device. Additionally, an oxide layer 300 is formed on a top surface of the first poly-Si layer 210, which can not only prevent possible damage to the surface of the first poly-Si layer 210 due to contamination and thereby provide protection to the first poly-Si layer 210, but can also facilitate performance of the subsequent processes. Furthermore, with the oxide layer 300 in the second patterned region 120 being protected, the oxide layer 300 in the first patterned region 110 is etched (e.g., in order to remove the oxide layer 300 from the first patterned region 110, with the oxide layer 300 in the second patterned region 120 being retained). In this way, in the subsequent CMP on the first poly-Si layer 210 in the first patterned region 110 and on the oxide layer 300 and the first poly-Si layer 210 in the second patterned region 120, the property of the polishing slurry used that it can polish away the oxide layer 300 in spite of a slow removal rate is fully utilized to enable the first poly-Si layer 210 to eventually have a uniform thickness across the first patterned region 110 and the second patterned region 120 because of a higher polishing rate of the second patterned region 120 due to the loading effect following the removal of the oxide layer 300, thereby improving the reliability of the resulting semiconductor device while entailing a simple process, which is highly flexible and easy to implement.

For example, the semiconductor substrate 100 provided in step S100 as discussed above may be any suitable substrate material known in the art, such as at least one of the following materials: silicon (Si), germanium (Ge), silicon germanium (SiGe), silicon carbide (SiC), silicon germanium carbide (SiGeC), indium arsenide (InAs), gallium arsenide (GaAs), indium phosphide (InP) or other III-V compound semiconductors. Other examples of the semiconductor substrate may include those consisting of multiple layers of one or more of the above materials, double-side polished (DSP) substrates, alumina and other ceramic substrates, and quartz or glass substrates. For example, in the present embodiment, the semiconductor substrate 100 may be, for example, a silicon wafer. For example, in the semiconductor substrate 100, the first patterned region 110 may be intended for the formation of semiconductor memory cells therein, and the second patterned region 120 for PIP capacitors therein. The first patterned region 110 may be contiguous with the second patterned region 120, or not, depending on the layout design of the wafer or chips thereon. The location and contiguity of the regions may be determined, as required by the products being fabricated. Notably, and as would appreciated by those skilled in the art, although the first patterned region 110 of the semiconductor substrate 100 has been described above as being intended for the formation of semiconductor memory cells therein and the second patterned region 120 for PIP capacitors therein, this is merely to exemplify that the first patterned region 110 and the second patterned region 120 are intended for the formation of different semiconductor features of different functions therein, but not intended to limit the present invention to any particular type of semiconductor device. Further, since only steps S100 to S300 in the method according to embodiments disclosed herein are essentially related to the inventiveness of the present invention, Figs. 4a to 4d depict only elements in relation to these inventive steps.

For example, Fig. 4a shows a cross-sectional view of an intermediate semiconductor structure resulting from step S100 ("FG Poly-Si Deposition"). Preferably, in some exemplary embodiments, prior to forming the first poly-Si layer 210 on the semiconductor substrate 100 by FS poly-Si deposition in step S100, the method further includes:
forming an insulating layer 600 over the semiconductor substrate 100 and a plurality of isolation structures 500 in the semiconductor substrate 100 on the side thereof proximal to the insulating layer 600 so that top surfaces of the resulting isolation structures 500 are raised over a top surface of the insulating layer 600.

The formation of the first poly-Si layer 210 on the semiconductor substrate 100 by FS poly-Si deposition may include:
forming the first poly-Si layer 210 on the top surface of the insulating layer 600 by FS poly-Si deposition so that a top surface of the first poly-Si is higher than the top surfaces of the isolation structures 500.

Through forming the insulating layer 600 over the semiconductor substrate 100 and the isolation structures 500, the top surfaces of the isolation structures 500 are raised over the top surface of the insulating layer 600, the semiconductor features can be isolated from one another, preventing leakage or issues. Moreover, stress may be relieved, helping to protect the subsequently formed semiconductor features from possible damage. For example, as shown in Figs. 4a to 4b, the isolation structures 500 are denser in the first patterned region 110 than in the second patterned region 120, ensuring that the first patterned region 110 has a higher feature density than the second patterned region 120.

Notably, and as would appreciated by those skilled in the art, the present invention is not limited to any particular material of the isolation structures 500, or to any particular method for forming them. For example, their formation may involve: forming trenches by performing deposition, patterning and silicon etching processes, in the presence of a silicon nitride mask; and filling the trenches with oxide(s) by deposition. For more details of the isolation structures 500, reference is made to related techniques well known in the art, and further description thereof is omitted herein. Likewise, the present invention is not limited to any particular material of the insulating layer 600, or to any particular method for forming it. For example, the formation of the insulating layer 600 may be accomplished by depositing a thin OX/SIN/OX(ONO), SIN/OX/SIN/OX/SIN(NONON) or other high-k (or high dielectric constant) dielectric film. In addition, in some embodiments, other films or layers may be further formed over the semiconductor substrate 100, without departing from the scope of the present invention.

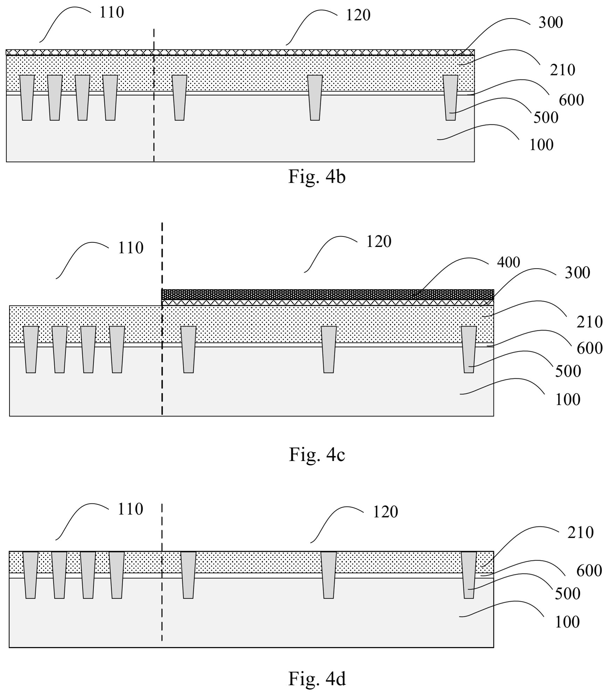

For example, Fig. 4b shows a cross-sectional view of an intermediate semiconductor structure resulting from the formation of the oxide layer 300 in step S200 ("FG Poly RTO"; RTO stands for "regenerative thermal oxidation"). In step S200, the formation of the oxide layer 300 on the top surface of the first poly-Si layer 210 may include performing a regenerative thermal oxidation (RTO) process on the top surface on the first poly-Si layer 210, thereby forming the oxide layer 300. The use of the RTO process allows for the formation of an ultrathin oxide layer 300 with high quality and prevents possible damage to the surface of the first poly-Si layer 210 due to contamination, thereby providing protection to the first poly-Si layer 210 and facilitating the performance of the subsequent processes.

It will be recognized that although the oxide layer 300 has been described herein as being formed on the top surface of the first poly-Si layer 210 by RTO, this is merely a preferred exemplary embodiment and is not intended to limit the present invention in any sense. The present invention is not limited to any particular material of the oxide layer 300, or to any particular method for forming it. For example, in some embodiments, the oxide layer 300 may be silicon dioxide. Apart from RTO, the formation may also be accomplished by, but is not limited to being accomplished by, wet oxidation or chemical vapor deposition (CVD).

In some exemplary embodiments, the oxide layer 300 is preferred to have a thickness of 20 Å to 30 Å. This not only can provide desired protection to the first poly-Si layer 210, but also allows for easy subsequent removal of the oxide layer 300. It will be understood that the present invention is not limited to any particular thickness of the oxide layer 300, and this thickness may be particularly dependent on a thickness of the first poly-Si layer 210, a thickness to be removed by polishing and/or the polishing technique used.

For example, the protection of the oxide layer 300 in the second patterned region 120 in step S300 may be accomplished by stacking a protective layer 400 on a top surface of the oxide layer 300 in the second patterned region 120. Stacking the protective layer 400 on the top surface of the oxide layer 300 in the second patterned region 120 lays a foundation for the subsequent polishing process on the first poly-Si layer 210 in the first patterned region 110 and the second patterned region 120 to result in a uniform thickness of the first poly-Si layer 210 across the first patterned region 110 and the second patterned region 120.

In some exemplary embodiments, as shown in Fig. 4c, the protective layer 400 preferably includes a photoresist layer. It will be understood that the present invention is not limited to any particular method for forming the photoresist layer. For example, the formation of the photoresist layer may be accomplished by chemical vapor transport (CVT) using a conventional photomask (PH). As a result, the oxide layer 300 in the second patterned region 120 is covered and the oxide layer 300 in the first patterned region 110 remains exposed, allowing the oxide layer 300 in the second patterned region 120 to survive the subsequent etching process. The present invention is not limited to any particular material of the protective layer 400, and an etch-resistant material is preferred. For example, the protective layer 400 (e.g., in the case of being implemented as a photoresist layer) may be a thin film of a new etch-resistant polymeric material formed by CVD. In this way, during the subsequent removal of the oxide layer 300 from the first patterned region 110, the excellent mechanical properties and chemical corrosion resistance of the protective layer 400 enable it to effectively protect the oxide layer 300 in the second patterned region 120. For example, in some exemplary embodiments, in step S300, the etching of the oxide layer 300 in the first patterned region 110 may be accomplished by a wet etching process and may result in removal of the oxide layer 300 from the first patterned region 110. Through removing the oxide layer 300 from the first patterned region 110 by wet etching while retaining the oxide layer 300 in the second patterned region 120, a good foundation is laid for complementary polishing to be achieved in the subsequent CMP process by different polishing rates of the oxide layer 300 and the first poly-Si layer 210 and the loading effect of the first and second patterned regions 110, 210.

For example, in some exemplary embodiments, the oxide layer 300 may be removed from the first patterned region 110 by a wet etching process using hydrofluoric acid as a main chemical etchant. This not only allows for more economic, more effective removal of the oxide layer 300 from the first patterned region 110, but can also help the protective layer 400 better protect the oxide layer 300 in the second patterned region 120 because of a weak erosive effect of hydrofluoric acid on the protective layer 400 in the second patterned region 120.

It should be noted that although the wet etching has been described as being accomplished using hydrofluoric acid (HF) as a main chemical etchant, this is merely a preferred exemplary embodiment and is not intended to limit the scope of the present invention. The present invention is not limited to any particular value of any wet etching parameter, and these parameters may be appropriately configured according to the material of the oxide layer 300. For example, in some preferred embodiments, phosphoric acid may be alternatively used as a main chemical etchant. It should be also noted that the present invention is not limited to any method for etching the oxide layer 300 in the first patterned region 110. For example, in some alternative embodiments, the oxide layer 300 may also be removed using a dry etching process. For more details of the wet and dry etching processes, reference is made to related techniques well known in the art, and further description thereof is omitted herein.

For example, Fig. 4c shows a cross-sectional view of an immediate semiconductor structure resulting from forming the photoresist layer in the second patterned region 120 and removing the oxide layer 300 from the first patterned region 110 in step S300 ("CVT PH & HF").

Fig. 4d shows a cross-sectional view of an immediate semiconductor structure resulting from the CMP process in step S400 ("CMP"). As can be easily found from a comparison made between Figs. 4d and 1c, the polishing process in the proposed method enables the resulting thickness of the first poly-Si layer 210 to be substantially uniform across the first patterned region 110 and the second patterned region 120, without any thinner portion in the second patterned region 120 (e.g., a PIP capacitor region). This can effectively ensure good reliability of the semiconductor device being fabricated.

Preferably, after the oxide layer 300 is etched away from the first patterned region 110 and the CMP process on the first poly-Si layer 210 in the first patterned region 110 and on the oxide layer 300 and the first poly-Si layer 210 in the second patterned region 120 in step S400 is completed, a cleaning process may be performed to enhance the quality of the semiconductor device.

For example, the formation of the semiconductor device on the basis of the first poly-Si layer 210 that has undergone the CMP process in step 500 may include: forming, over the top surface of the first poly-Si layer 210, at least an insulating dielectric layer and a second poly-Si layer stacked thereon; and selectively etching the first poly-Si layer 210, the insulating dielectric layer and the second poly-Si layer 220, thereby forming the semiconductor device.

It should be noted that the present invention is not limited to any particular method for forming the semiconductor device. In some preferred embodiments, PIP capacitors are formed in the second patterned region 120, and the second poly-Si layer and the first poly-Si layer 210 provide upper and bottom plates of the capacitors, respectively. Since the first poly-Si layer 210 in the second patterned region 120, which provides the bottom plates of the PIP capacitors, has a flat top surface, it is ensured that the resulting PIP capacitors have good reliability.

In some preferred embodiments, an array of memory cells is formed in the first patterned region 110, and the second poly-Si layer and the first poly-Si layer 210 provide control gates and floating gates of the memory cells, respectively. Through forming the memory cells in the first patterned region 110, with the second poly-Si layer and the first poly-Si layer 210 providing the control gates and floating gates of the memory cells, the formation of the PIP capacitors in the second patterned region 120 can be additionally facilitated, making the fabrication of the semiconductor device more efficient and ensuring good performance of the resulting semiconductor device.

As discussed above, the proposed method has the following advantages over the prior art:
In the method, a first poly-Si layer is first formed on a semiconductor substrate by FS poly-Si deposition, laying a foundation for the formation of poly-Si electrodes (e.g., in the case of the semiconductor device including PIP capacitors), high-resistance poly-Si or the like. This is followed by ion implantation, which can modify the conductivity, magnetic permeability and other properties of the first poly-Si layer, laying a foundation for further improving the performance of the semiconductor device. Additionally, an oxide layer is formed on a top surface of the first poly-Si layer, which can not only prevent possible damage to the surface of the first poly-Si layer due to contamination and thereby provide protection to the first poly-Si layer, but can also facilitate performance of the subsequent processes. Furthermore, with the oxide layer in the second patterned region being protected, the oxide layer in the first patterned region is etched (e.g., in order to remove the oxide layer from the first patterned region, with the oxide layer in the second patterned region being retained). In this way, in the subsequent CMP on the first poly-Si layer in the first patterned region and on the oxide layer and the first poly-Si layer in the second patterned region, the property of the polishing slurry used that it can polish away the oxide layer in spite of a slow removal rate is fully utilized to enable the first poly-Si layer to eventually have a uniform thickness across the first and second patterned regions because of a higher polishing rate of the second patterned region due to the loading effect following the removal of the oxide layer, thereby improving the reliability of the resulting semiconductor device while entailing a simple process, which is highly flexible and easy to implement.

The description presented above is merely that of a few preferred embodiments of the present invention and is not intended to limit the scope thereof in any sense. Any and all changes and modifications made by those of ordinary skill in the art in light of the above teachings fall within the scope as defined in the appended claims. Apparently, those skilled in the art can make various modifications and variations to the present invention without departing from the spirit and scope thereof. Accordingly, the invention is intended to embrace all such modifications and variations if they fall within the scope of the appended claims and equivalents thereof.

## Claims

1. A method of fabricating a semiconductor device, comprising:
providing a semiconductor substrate (100) and performing floating-gate polycrystalline silicon, poly-Si, deposition on the semiconductor substrate (100), thereby forming a first poly-Si layer (210), wherein the semiconductor substrate (100) comprises a first patterned region (110) and a second patterned region (120), the first patterned region (110) having a feature density higher than a feature density of the second patterned region (120);
performing ion implantation on the first poly-Si layer (210) and forming an oxide layer (300) over a top surface of the first poly-Si layer (210);
with the oxide layer (300) in the second patterned region (120) being protected, etching the oxide layer (300) in the first patterned region (110);
performing a chemical mechanical polishing, CMP, process on the first poly-Si layer (210) in the first patterned region (110) and on the oxide layer (300) and the first poly-Si layer (210) in the second patterned region (120); and
forming the semiconductor device on the basis of the first poly-Si layer (210) that has undergone the CMP process.

2. The method according to claim 1, comprising forming the oxide layer (300) over the top surface of the first poly-Si layer (210) by a thermal oxidation process.

3. The method according to claim 2, wherein the oxide layer (300) has a thickness of 20 Å to 30 Å.

4. The method according to claim 1, wherein the protection of the oxide layer (300) in the second patterned region (120) comprises stacking a protective layer (400) on a top surface of the oxide layer (300) in the second patterned region (120).

5. The method according to claim 4, wherein the protective layer (400) comprises a photoresist layer.

6. The method according to claim 1, wherein etching the oxide layer (300) in the first patterned region (110) comprises removing the oxide layer (300) from the first patterned region (110) by wet etching.

7. The method according to claim 6, comprising removing the oxide layer (300) from the first patterned region (110) by performing a wet etching process using hydrofluoric acid.

8. The method according to claim 1, wherein forming the semiconductor device on the basis of the first poly-Si layer (210) that has undergone the CMP process comprises:
forming, over the top surface of the first poly-Si layer (210), at least an insulating dielectric layer and a second poly-Si layer (220) stacked on the insulating dielectric layer; and
selectively etching the first poly-Si layer (210), the insulating dielectric layer and the second poly-Si layer (220), thereby forming the semiconductor device.

9. The method according to claim 8, wherein poly-insulator-poly capacitors are formed in the second patterned region (120), wherein the second poly-Si layer (220) and the first poly-Si layer (210) provide a top plate and a bottom plate of the poly-insulator-poly capacitors, respectively.

10. The method according to claim 8, wherein an array of memory cells is formed in the first patterned region (110), wherein the second poly-Si layer (220) and the first poly-Si layer (210) provide control gates and floating gates of the memory cells, respectively.

11. The method according to any one of claims 1 to 10, further comprising, before the floating-gate poly-Si deposition is performed on the semiconductor substrate (100):
forming an insulating layer (600) over the semiconductor substrate (100) and a plurality of isolation structures (500) in the semiconductor substrate (100) on the side thereof proximal to the insulating layer (600), top surfaces of the isolation structures (500) are raised over a top surface of the insulating layer (600),
wherein the forming the first poly-Si layer (210) on the semiconductor substrate (100) by the floating-gate poly-Si deposition comprises:
forming the first poly-Si layer (210) on the top surface of the insulating layer (600) by the floating-gate poly-Si deposition, a top surface of the first poly-Si is higher than the top surfaces of the isolation structures (500).

12. A semiconductor device, comprising:
a semiconductor substrate (100) comprising a first patterned region (110) and a second patterned region (120), wherein the first patterned region (110) has a feature density higher than a feature density of the second patterned region (120); and
a first poly-Si layer (210) disposed over the semiconductor substrate (100);
wherein the first poly-Si layer (210) has a substantially uniform thickness in both the first patterned region (110) and the second patterned region (120).

13. The semiconductor device of claim 12, wherein a top surface of the first poly-Si layer (210) is planar and is devoid of dishing in the second patterned region (120).

14. The semiconductor device of claim 12, further comprising:
an insulating layer disposed on the first poly-Si layer (210); and
a second poly-Si layer (220) disposed on the insulating dielectric layer.

15. The semiconductor device of claim 12, further comprising an insulating layer (600) over the semiconductor substrate (100) and a plurality of isolation structures (500) in the semiconductor substrate (100) on the side thereof proximal to the insulating layer (600), top surfaces of the isolation structures (500) are raised over a top surface of the insulating layer (600), wherein a top surface of the first poly-Si is higher than the top surfaces of the isolation structures (500), the isolation structures (500) are denser in the first patterned region (110) than in the second patterned region (120).
